# FASCICULE DE BREVET EUROPEEN

(11) **EP 0 785 583 B1**
(45) Date de publication et mention de la délivrance du brevet: **19.02.2003**
(21) Numéro de dépôt: 96402837.7
(22) Date de dépôt: 20.12.1996
(51) Int. Cl.: H01L 41/18, H01L 41/22, H01F 1/44

(54) **Procédé de fabrication d'un matériau piézo-sensible**
Verfahren zum Herstellen eines druckempfindlichen Materials
Method of making a pressure-sensitive material

(30) Priorité: 15.01.1996 FR 9600368
(43) Date de publication de la demande: 23.07.1997
(73) Titulaire: DELEGATION GENERALE POUR L'ARMEMENT, Paris - 7ème (FR)
(72) Inventeur: Dejugnac, Corinne, 83500 La Seyne/Mer (FR); Scarpitta, Alain, 83200 Toulon (FR); Boisrayon, Michel, 83330 Beausset (FR)

(56) Documents cités:
- US-A- 4 285 819
- PATENT ABSTRACTS OF JAPAN vol. 006, no. 191 (C-127), 30 Septembre 1982 & JP 57 102188 A (YAMASHITA TOSHIHARU;OTHERS: 01), 25 Juin 1982,

## Description

L'invention concerne les domaines de la piézo-électricité et du magnétisme et a notamment pour objet un procédé de fabrication d'un matériau piézo-électrique ou magnétique ainsi que les matériaux obtenus par un tel procédé.

Dans le domaine de la piézo-électricité ou celui du magnétisme, il est connu d'utiliser des matériaux composites utilisant une matrice et des particules.

Ainsi, un matériau magnétique peut être utilisé dans certains dispositifs tels que des magnétomètres, des boussoles, ou des capteurs de cap magnétiques.

Les composites magnétiques réalisés couramment mettent en oeuvre des particules ou grains de substances magnétiques qui proviennent de matériaux tels que les ferrites, comme l'oxyde de fer magnétique (FeO) (*Fe*_{*2*}*O*_{*3*}), ferrite naturelle constituée d'ions *Fe*²⁺ et *Fe*³⁺, ou autres ferrites à base de Co, de Cu, de Mn, de Mg ou de Li associées à des ions *Fe*²⁺ et *Fe*³⁺ sous forme d'oxydes.

Ces grains de substance magnétique présentent un inconvénient majeur: leurs tailles et leur formes sont assez irrégulières car ils sont obtenus à la suite d'opérations de broyage éventuellement complétées d'opérations de tamisage, ces dernières opérations augmentant très sensiblement le coût de fabrication desdits grains. Or, pour réaliser des composés magnétiques de bonne qualité, il est nécessaire de leur conférer une grande homogénéité physico-chimique, qui n'est pas forcément assurée par le procédé de fabrication décrit.

De même, un matériau composite piézoélectrique peut être utilisé dans des capteurs, de type transducteurs électromécaniques. Ces transducteurs peuvent être des hydrophones, des accéléromètres, des capteurs de pression hydrostatique, de déformation, de force ou de température ou des systèmes complexes pouvant associer ces différentes fonctions. Ces transducteurs peuvent également être utilisés, dans l'air, dans des microphones, des claviers de téléscripteurs ou d'ordinateurs, des détecteurs de chaleur ou des revêtements piézo-chromes.

Un inconvénient des matériaux piézoélectriques, décrits dans les brevets antérieurs et comportant des particules piézo-électriques réside dans le fait que ces dernières ont des tailles qui sont supérieures au micron, la dispersion de taille allant de quelques microns à plusieurs centaines de microns. Or, tout comme les matériaux composites magnétiques, l'une des conditions permettant d'obtenir un matériau composite piézo-électrique de bonne qualité réside dans la régularité de forme et de taille des particules, comme il est expliqué dans le brevet US 4,407,054 par exemple.

La demande de brevet français FR9413743, publiée sous le numéro 2 719181 résout en partie cet inconvénient. En effet, elle décrit :
- d'une part des dispositifs piézo-sensibles à polarisation variable utilisant un matériau piézo-sensible constitué d'un agglomérat de particules ou composé d'une matrice de polymère ou de produit organique diélectrique, non piézo-électrique ou faiblement piézo-électrique, et de particules piézo-électriques,
- d'autre part, plusieurs procédés de fabrication de ces particules en fonction de leur taille désirée.

On peut, par exemple, découper, à l'aide d'un massicot, des feuilles ou des plaques de matières plastiques piézo-électriques pré polarisées dans le sens de l'épaisseur ou non pré polarisées, ou sectionner des fils.

On peut aussi, lorsqu'on synthétise des monocristaux d'origine minérale comme la brushite ou le sel de Seignette, accélérer le processus de cristallisation en agitant la solution par vibration ou par ultrasons. On détermine ainsi la formation de cristallides de taille beaucoup plus faible que celle des particules obtenues généralement par des procédés ordinaires.

On peut encore, lorsque l'on utilise des matériaux biologiques présentant en eux-mêmes des propriétés piézo-électriques, diviser ces matériaux par ultra-centrifugation différentielle, cette technique permettant d'obtenir des particules ayant une taille de l'ordre 5.10⁻⁹m.

Toutefois, la taille et la forme des particules obtenues par ces procédés présentent encore une certaine dispersion inhérente au procédé de fabrication.

Par ailleurs, on connaît le brevet JP57102188 qui décrit la synthèse d'une substance piézolectrique, le FX100 par des levures de la famille des Saccharomyces, le FX100 étant séparé des levures par filtration. Après recristallysation, la substance est utilisée en complément de l'essence pour améliorer la combustion.

On connaît aussi le brevet US4285819 qui décrit un procédé de fabrication de particules magnétiques consistant à dissoudre un mucopolysaccharide, tel que du chitosan ou du glucosamine, dans une solution acide contenant un mélange de chlorure ferreux et de chlorure ferrique. Ainsi des microsphères de mucopolysaccharides contenant une dispersion de Fe3O4 sont obtenues. Ces mucopolysaccharides sont des produits d'hydrolyse de la chitine qui est un composant principal de la carapace des crustacés et coléoptères.

L'un des buts de l'invention est de fournir un procédé permettant l'obtention de particules piézo-sensibles avec une régularité de taille et de forme accrues et ne nécessitant ni la production de FX100 ni l'utilisation de produits purifiés issus d'un traitement de la chitine elle-même extraite de la carapace d'un crustacé ou d'un coléoptère.

Pour cela, un procédé de fabrication de particules selon l'invention consiste :
- à mettre en culture des micro-organismes dans un milieu nourricier et en présence d'une poudre piézo-électrique, ou d'une poudre magnétique, ces micro-organismes étant aptes à fixer ladite poudre,
- à extraire, après culture, les micro-organismes "chargés" du milieu nourricier,
- à déshydrater ces micro-organismes afin d'obtenir des particules sèches,
- à compacter lesdites particules ou à les insérer dans une matrice pour constituer un matériau composite pour former un matériau piézo-sensible ou magnétique.

Selon une caractéristique particulière, la déshydratation des micro-organismes est réalisée par lyophilisation.

Selon une caractéristique particulière, l'extraction des micro-organismes chargés de la culture est réalisée par centrifugation.

Un tel procédé peut être mis en oeuvre pour la fabrication d'un matériau piézo-sensible. Il comporte dans ce cas une étape supplémentaire consistant à compacter lesdites particules sèches ou à les insérer dans une matrice pour constituer un matériau composite pour former un matériau piézo-sensible. Aussi, selon l'invention, un matériau piézo-sensible ou magnétique est caractérisé en ce qu'il comporte des particules piézo-sensibles ou magnétiques, ces particules comportant des micro-organismes déshydratés.

Selon une caractéristique particulière, au moins une partie des particules comportent une enveloppe en matière piézo-sensible à l'intérieur de laquelle se situe un micro-organisme déshydraté.

Selon une caractéristique additionnelle, les particules de ladite partie sont de forme quasi-sphérique et ont une taille comprise entre 1 et 6µm.

Selon une autre caractéristique, les particules de ladite partie sont de forme de bâtonnet, la longueur étant comprise entre 1 et 10µm, et la largeur comprise entre 0,5 et 5µm.

Dans le cas où, les micro-organismes fixent les poudres piézo-sensibles ou magnétiques à l'intérieur de leur cellule, un procédé selon l'invention peut consister en outre, après avoir déshydraté les micro-organismes chargés, à séparer les particules piézo-sensibles ou magnétiques des micro-organismes, cette séparation pouvant consister à plonger les micro-organismes chargés dans de l'eau de Javel.

Enfin, sans cette étape de séparation, un matériau piézo-sensible ou magnétique selon l'invention est caractérisé en ce qu'au moins une partie des particules comportent une enveloppe constituée d'un micro-organisme déshydraté à l'intérieur de laquelle se trouve une particule piézo-sensible ou magnétique.

Le milieu nourricier cité précédemment peut par exemple être solide et constitué par de la gélose, ou liquide et constitué alors par un liquide nourricier du type bouillon.

A titre d'exemple, la poudre piézo-sensible peut être choisie parmi le sel de Seignette, l'acide tartrique, le sulfate de lithium, le dihydrogènephosphate d'ammonium, le dihydrogènephosphate de potassium, le tartrate d'ammonium, le tartrate de potassium, le tartrate de diamine éthylène, le tartrate de dipotassium, le chlorate de sodium, le bromate de sodium, l'hexahydrate de sulfate de nickel, l'acide iodique, le monohydrate de terpène, le benzophénone, le gallate de lithium hydraté, ou déshydraté, les polypeptides synthétiques d'alkylglutamate ou d'arylglutamate, les poly-γ-méthyl-L-glutamates, les poly-γ-benzylglutamates, les copolymères de β-hydroxybutarate ou de β-hydroxyvalérate, les poly-β-hydroxybutarates, les monosaccharides, les disaccharides, les oligosaccharides, les homopolysaccharides, les hétéropolysaccharides, les glycosaminoglycanes, les sels d'acide carboxylique, la brushite, la monétite, les cholestérols et stérols, l'urée, les acides aminés, les dipeptides ou les polypeptides, les nucléotides ou les acides nucléiques.

Dans la suite du texte, il faut entendre par "micro-organisme chargé", un micro-organisme, tel par exemple une bactérie, une levure, un champignon ou un protozoaire, ayant fixé une certaine quantité de matière piézo-sensible.

Dans le but d'appliquer l'invention à des transducteurs, les particules piézo-sensibles ainsi obtenues sont compactées afin de former un agglomérat piézo-sensible ou insérées dans une matrice de polymère ou de produit organique diélectrique, non piézo-électrique ou faiblement piézo-électrique, pour former un matériau composite piézo-sensible.

Les colonies des souches de micro-organismes magnétiques obtenues selon l'invention pourront par exemple être utilisées, à l'état d'êtres vivants, comme éléments sensibles pour concevoir des capteurs dotés d'une certaine intelligence ou, à l'état de poudres inertes, comme oligo-éléments à des fins médicales.

D'autres avantages et caractéristiques de la présente invention apparaîtront dans la description de variantes de réalisation appliquées principalement à des hydrophones, en regard des figures annexées parmi lesquelles :
- les figures 1a à 1c présentent des exemples de forme de micro-organismes chargés en matière piézo-sensible ou en matière magnétique,
- la figure 2 présente un schéma d'un moule servant à la fabrication d'un matériau piézo-électrique selon l'invention,
- la figure 3 montre un schéma des moyens de raccordement électriques des électrodes,
- la figure 4 présente un outillage permettant de réaliser un matériau piézo-sensible selon l'invention.

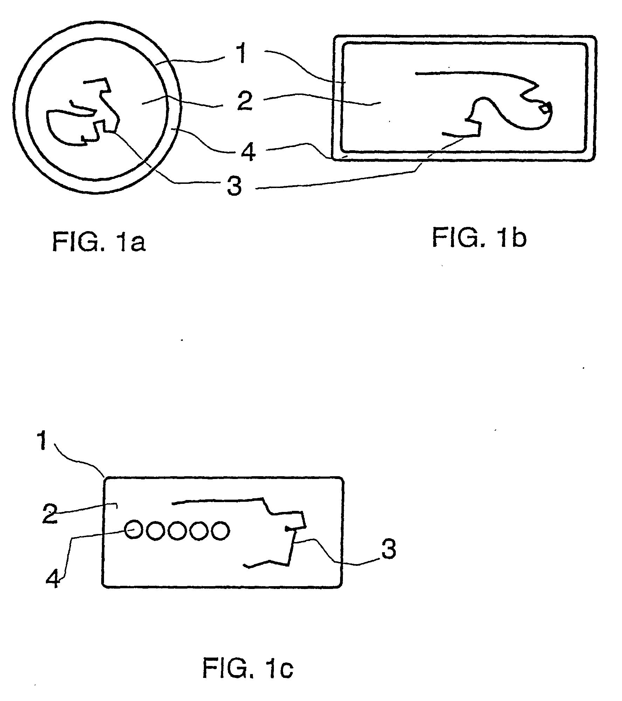

Les figures 1a et 1b présentent deux exemples de forme de micro-organismes chargés en matière piézo-sensible ou en matière magnétique. Les micro-organismes sont schématisés par leur membrane 1, leur cytoplasme 2 et leur ADN 3. Dans ces exemples, la matière piézo-sensible ou magnétique 4 est fixée à la périphérie du micro-organisme et la particule piézo-sensible ou magnétique respectivement obtenue à l'issue de son procédé de fabrication a des dimensions voisines de celles du micro-organisme support. Ainsi la plus grande dimension d'une particule de ce type va de quelques microns à plusieurs centaines de microns et la géométrie de l'élément piézo-sensible ou magnétique obtenu est celle du micro-organisme qui sert de support.

La figure 1c présente un autre exemple de micro-organisme chargé en matière piézo-sensible ou en matière magnétique. Dans cet exemple, le micro-organisme a ingéré la matière piézo-sensible ou la matière magnétique puis l'a fixée dans son cytoplasme 2, sous forme de particules. Les particules fixées, ainsi obtenues ont des dimensions très voisines les unes des autres à l'issue de leur recristallisation dans le cytoplasme ; la géométrie de ces particules est invariable et définie par la structure cristalline du réseau de départ avant mise en solution dans un milieu nourricier.

Dans le cas des figures 1a et 1b, appelé cas A, les micro-organismes, les levures ou les bactéries sont cultivés dans un milieu nourricier comprenant en outre la substance piézo-sensible ou magnétique que l'on désire fixer à la surface des cellules.

Le milieu nourricier peut être constitué par une gélose ou par un milieu nutritif liquide. L'emploi de la gélose permet de contrôler le développement des colonies de micro-organismes.

La substance piézo-sensible ou magnétique se présente sous forme d'une poudre dont la taille des grains n'excède généralement pas respectivement 100 ou 20 microns. Cette poudre est incorporée à la gélose après avoir déterminé la concentration létale de produit piézo-sensible ou magnétique. Cette concentration varie suivant la nature de la substance. Elle est de l'ordre de 2 % pour le sulfate de lithium hydraté et elle atteint 10 % pour l'acide tartrique, ces substances étant piézo-sensibles; pour le fer en poudre, qui est une substance magnétique, elle est de l'ordre de 10% .

L'utilisation de certains produits non létaux, comme le sel de Seignette dans le cas de substances piézo-sensibles, peut-être, pour cette raison, recommandée.

L'incorporation de la substance piézo-sensible ou magnétique est effectuée en faisant fondre la gélose à une température convenable, mais qui ne doit en aucun cas excéder la température de fusion de ladite substance. En effet, certaines substances peuvent perdre leurs propriétés de manière irréversible si on les porte à des températures trop élevées. Dans ce cas, il est préférable de faire appel à un liquide nourricier et non à une gélose.

Les particules constituant la poudre sont stérilisées avant mélange. Les opérations ultérieures doivent être exécutées de préférence en milieu stérile ou sous une hotte à flux laminaire. Le mélange de gélose et de particules doit être agité en permanence jusqu'à refroidissement complet. Il est très important d'obtenir une gélose dont la pellicule de surface soit imprégnée, avec une concentration convenable, de la substance.

Après refroidissement de la gélose, les colonies de micro-organismes sont déposées à sa surface pour l'ensemencer. La durée d'incubation est de l'ordre de 48 heures. Dans cet intervalle, la croissance des colonies est contrôlée au moyen de prélèvements réguliers et d'observations au microscope. A l'issue de ce processus, les colonies sont prélevées en surface au moyen de râteaux de pipettes. Pour de très faibles quantités on peut se contenter d'employer une ose. L'emploi de la gélose est cependant moins efficace dans le cas A que l'emploi d'une solution nourricière

Une solution nourricière se présente sous forme d'un liquide plus ou moins épais, appelé bouillon, qui contient les mêmes éléments nutritifs (protéines, sucres, vitamines, eau dans des proportions convenables) que la gélose. La composition du bouillon dépend des micro-organismes utilisés.

Comme précédemment, la substance, piézo-sensible ou magnétique se présente sous forme d'une poudre dont la taille des grains n'excède généralement pas respectivement 100 ou 20 microns. Cette poudre est incorporée au bouillon après avoir déterminé, comme pour la gélose, la concentration létale de produit piézo-sensible ou magnétique. Elle est de l'ordre de 2,5 % pour le sulfate de lithium hydraté, elle atteint 10 % pour l'acide tartrique et de 10% pour le fer en poudre. Certains produits tels le sel de Seignette ne sont pas létaux et peuvent être recommandés pour cette raison.

L'incorporation de la substance est effectuée en versant cette substance à température ambiante dans le bouillon nourricier. Pour faciliter la mise en solution de cette substance on peut, dans certains cas, chauffer le bouillon jusqu'à des températures n'excédant pas 30° C.

Les particules doivent être stérilisées avant mélange. Les opérations ultérieures doivent être exécutées de préférence en milieu stérile ou sous une hotte à flux laminaire. Le bouillon chargé en particules doit être agité en permanence jusqu'à dissolution complète des particules.

Après dissolution on laisse reposer le bouillon. La durée d'incubation est de l'ordre de 48 heures à 37°C. Dans cet intervalle la croissance des colonies est contrôlée au moyen de prélèvements réguliers et d'observations au microscope. A l'issue de ce processus, les colonies sont centrifugées dans un tube de centrifugation, pendant une durée convenable, de façon à obtenir la formation d'un culot. Le liquide qui surnage au-dessus du culot est éliminé à la pipette et le culot est récupéré à la spatule.

Les micro-organismes récupérés à l'issue de ces opérations effectuées à partir d'une gélose ou d'une solution sont ensuite lyophilisés de la manière suivante.

Le principe de la lyophilisation est de sublimer les solvants présents au sein d'un échantillon en portant celui-ci à basse température et à basse pression. Pour cela, les micro-organismes récupérés sont préalablement congelés afin d'obtenir la phase solide. L' étape suivante consiste à abaisser la température de la cuve dans laquelle les échantillons congelés vont être placés. Lorsque la température de celle-ci a atteint -20°C, le circuit de refroidissement du piège est lancé. C'est à ce moment que les vapeurs du solvant sont prélevées. Cette opération dure en moyenne 15 minutes, elle est achevée lorsque la température du piège atteint -45°C. Les échantillons sont ensuite placés dans la cuve à -20° C et on réalise le vide. Cette étape s'effectue par palliers jusqu'à une pression dans la cuve de 3,10⁻² Pa et dure environ 30 minutes. Les échantillons sont laissés à lyophiliser pendant 24 heures, pour un volume de 50 ml, afin d'être sûr du bon résultat de l'opération.

Dans le cas de la figure 1c, appelé cas B, le procédé diffère du procédé utilisé dans le cas A uniquement dans la phase finale qui comporte une opération supplémentaire d'extraction des particules ingérées par les micro-organismes.

Ces particules piézo-sensibles peuvent être extraites des micro-organismes récupérés après lyophilisation en plongeant lesdits micro-organismes dans une solution d'eau additionnée d'eau Javel. L'eau de Javel dissout les membranes ou les parois cellulaires des micro-organismes en l'espace de quelques heures. La solution est ensuite évaporée et les résidusLes produits obtenus dans le cas B sont plus petits que ceux obtenus dans le cas A et exigent des opérations d'extraction délicates et coûteuses. L'invention privilégie donc le procédé correspondant au cas A.

Dans l'un et l'autre des cas, les particules finalement obtenues peuvent être compactées pour former un agglomérat piézo-sensible, ou insérées dans une matrice de polymère ou de produit organique diélectrique, non piézo-électrique ou faiblement piézo-électrique, et ce, pour former un matériau composite piézo-électrique.

A titre d'exemple, le matériau constitutif de la matrice de polymère ou le produit organique diélectrique, non piézo-électrique ou faiblement piézo- cellulaires sont séparés des granules piézo-sensibles par ultra-centrifugation, électrique peut être choisi parmi les polystyrènes, polysulfones, polycarbonates, polypropylènes, polyéthylène, téréphtalates de polyéthylène, oxydes de polyphénylène, les elastomères de polyuréthanne, les polyvinylecarbazols et les fluorures de polyvinylidène, les esters de polyacrylate ou de de polyméthacrylate, les chlorures de polyvinyle, polyvinylidènes, les polymères d'acrylonitrile ou de méthacrylonitriles, les acétates de polyvinyle, celluloïdes, acétates de cellulose, polyvinylepyrrolidones, polymères cellulosiques, phénol-formaldéhydes, les résines phénols-furfural, les polymères solubles de polyimide, les résines époxydes, les résines polymérisables, les caoutchoucs naturels, les caoutchoucs synthétiques, les résines silicones, les colles de carbinol ou d'os, les polystyrols, les gommes laque, ou les copolymères de vinylidène et de trifluorèthylène.

### EXEMPLE 1 (levures et sel de Seignette sur milieux solides) :

Dans cet exemple de fabrication d'un matériau piézo-sensible selon l'invention, le micro-organisme utilisé est une levure appelée "Saccaromyces cerevisiae" qui est une cellule eucaryote. Cette cellule présente la particularité d'avoir une taille relativement importante, puisque de l'ordre de 5 microns.

Le procédé exige la préparation de milieux de culture solides. La gélose Sabouraud, fournie par la Société BIOCAR est choisie comme milieu préférentiel. Cette gélose est en effet particulièrement adaptée à la sélection, l'identification, et la culture des levures et des moisissures.

Elle est préparée de la façon suivante. On met 45 g de poudre de gélose déshydratée dans un litre d'eau distillée, on attend 5 minutes sans agiter le milieu, puis on agite le milieu, au moyen d'un agitateur mécanique à ailettes, jusqu'à obtention d'une suspension homogène appelée ALPHA. Au cours de cette dernière opération, on chauffe lentement le milieu dans une cuve thermostatée, jusqu'à une température voisine de l'ébullition. Il n'est pas nécessaire que l'agitation soit continue mais elle doit être fréquente. L'opération s'arrête lorsqu'on obtient la dissolution complète de la poudre de gélose.

Un antibiotique à large spectre antimicrobien est rajouté au milieu ALPHA, à la concentration de 100 mg/L, afin de rendre le milieu ALPHA plus sélectif et de réduire par conséquent le développement de bactéries ou de micro-organismes indésirables.

Le milieu ALPHA est ensuite stérilisé en le passant à l'autoclave à 120°C pendant 20 mn. Après stérilisation il est ensuite ramené à une température de l'ordre de 45°C.

La substance piézo-sensible utilisée dans l'exemple est de la poudre de sel de Seignette. Cette poudre se présente sous forme de grains ayant une_taille moyenne de 500 microns et une taille maximale de 1 mm. Cette poudre est stérilisée au moyen d'une lampe à rayons ultra-violets fonctionnant à une longueur d'onde de 254 nm. Puis elle est mélangée au milieu ALPHA maintenu à une température de 45°C. Le milieu ALPHA doit être en effet suffisamment liquide pour que le mélange se fasse, mais la température de mélange doit être suffisamment basse pour que la substance piézo-sensible ne soit pas liquéfiée. Le sel de Seignette a en effet une température de fusion de 55°C. Après mélange on obtient le milieu BETA.

La quantité de produit piézo-sensible mélangée dans le milieu de culture est choisie de manière à obtenir une concentration finale non toxique pour les levures. La concentration létale a été déterminée par une étude de cytotoxicité faite au préalable. Elle est de l'ordre de 0,1 g par gramme de milieu ALPHA. On a utilisé 50 g de poudre de sel de Seignette pour produire le milieu BETA, ce qui est au-dessous de la concentration létale (100g).

Le milieu BETA ainsi obtenu est coulé (volume de 20 ml) en boîte de Pétri de 9 cm de diamètre.

Une solution mère est établie par dilution de manière à obtenir une concentration de 3000 levures par ml de suspension. Ainsi en ensemençant 100µl de cette suspension il apparaitra des colonies (300 environs) isolées sans formation d'une nappe continue.

Des sels de calcium (carbonate de calcium et acétate de calcium) sont utilisés pour fragiliser la membrane des levures. En altérant celle-ci, elle devient plus facilement pénétrable. Ces sels de calcium sont préparés à la concentration de 50g/l.

Pour un milieu de culture BETA donné, contenant du sel de SEIGNETTE, on peut donc mélanger 0,2ml de solution mère avec 0,1ml d'acétate de calcium. La solution mère modifiée au moyen de sels de calcium sera appelée GAMMA.

On notera qu'avant utilisation cette suspension GAMMA est laissée 5 minutes à température ambiante, afin que le sel de calcium puisse agir sur les levures.

Dans la phase suivante on étale 100 µl de solution mère GAMMA sur le milieu BETA. Ce milieu est mis à incuber 24 heures à 37°C en étuve. A l'issue de cette opération on a déposé, sur la face externe de la membrane des levures, une couche continue ou discontinue de sel de Seignette. Les colonies sont ensuite prélevées en surface au moyen d'une öse ou, pour des quantités plus importantes, par l'intermédiaire de râteaux de pipettes.

Pour contrôler l'efficacité du processus, on prélève des levures modifiées par le procédé, on les dépose dans une gouttelette de liquide diélectrique (huile silicone par exemple), elle-même placée entre deux électrodes planes en scotch-cuivre collées sur une lame de verre, et on applique entre ces électrodes un champ électrique d'au moins 200 V/mm. Les levures forment alors des alignements perpendiculaires aux électrodes.

Dans une phase ultérieure, les colonies prélevées sont lyophilisées puis insérées dans une matrice de polymère pour former un matériau composite .

Aussi, à titre d'exemple, pour la réalisation d'un hydrophone utilisant un tel matériau dans lequel la matrice est une résine silicone fournie par la Société RHODORSYL, le procédé de réalisation de l'ensemble matériau- électrodes peut être le suivant.

La résine silicone se présente sous la forme d'une résine A et d'un durcisseur B.

Quarante grammes de résine et quatre grammes de durcisseur sont mélangés au moyen d'un mélangeur et environ 2 grammes de particules de sel de Seignette sont incorporés progressivement dans le mélange de pré polymère, et ce, jusqu'à homogénéisation complète. Le mélange est ensuite dégazé au moyen d'une pompe à vide.

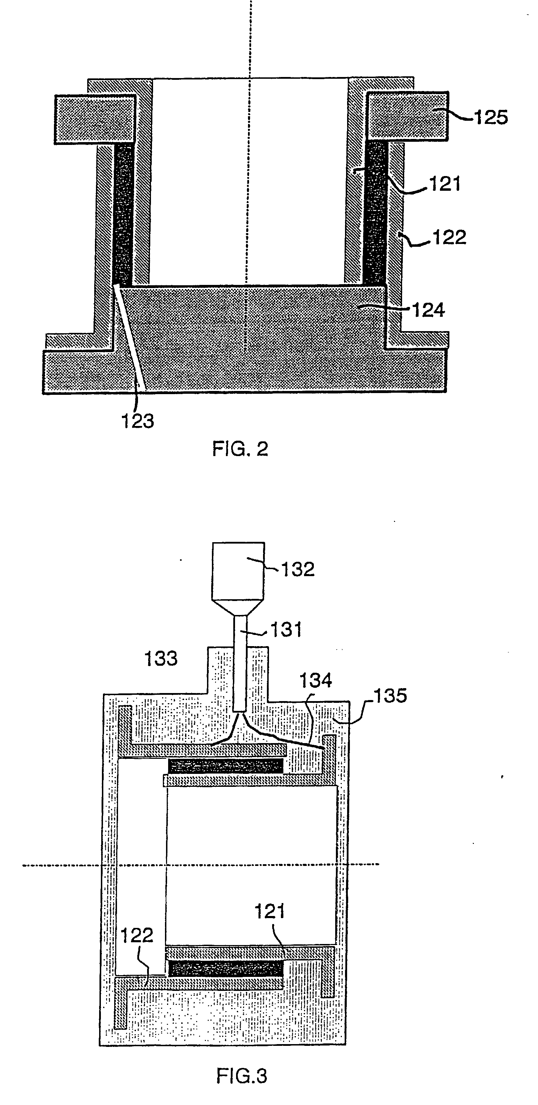

La résine étant toujours à l'état de pré polymère le mélange est injecté, à travers un orifice d'injection 123 , dans un moule , montré à la figure 2, en matière plastique et pourvu d'électrodes métalliques. Ce moule a la forme d'un cylindre. Il comprend deux parties 124,125 en Plexiglas et les électrodes sont constituées par deux cylindres métalliques 121 et 122 en bronze d'aluminium. On laisse le mélange de résine et de microcristaux se polymériser pendant 48 heures. On rapporte sur les électrodes 121 et 122, comme montré sur la figure 3, un câble électrique coaxial 131,et équipé à son extrémité extérieure d'une prise 132. La tresse 133 du câble 131 est reliée à l'électrode externe 122. Le conducteur central 134 du câble 131 est relié à l'électrode interne 121. L'ensemble est placé dans un autre moule pour recevoir un enrobage extérieur 135 de résine polyuréthanne. Au cours de cette opération, une partie du câble 131 est surmoulée par l'enrobage 135. On obtient ainsi un capteur qui est utilisé comme hydrophone.

### EXEMPLE 2 (levures et fer en poudre en milieu solide):

Dans cet exemple de fabrication d'un matériau magnétique selon l'invention en milieu solide, le procédé et ses étapes sont strictement identiques à l'exemple 1, à l'exception des produits mis en jeu. En effet, une poudre d'oxyde de fer de type FeO.OH d'une masse de 80g se substitue au sel de seignette pour produire le milieu BETA, les levures ayant ingéré cette poudre à l'issue de l'opération d'incubation de 24 heures à 37°.

Dans le but de contrôler l'efficacité du processus on prélève des levures modifiées par le procédé, on les dépose dans une goutelette d'eau distillée, elle-même placée dans l'entrefer d'un électro-aimant dans lequel l'induction magnétique est d'au moins un Tesla. Les levures forment alors des alignements perpendiculaires aux surfaces des mâchoires de l'électro-aimant.

### EXEMPLE 3 (levures et sel de Seignette en milieu liquide) :

Le milieu de culture se présente sous forme d'un liquide appelé bouillon Sabouraud, fourni par la Société BIOCAR. Il est préparé de la façon suivante. On met 30 g de poudre de gélose dans un litre d'eau distillée, puis on agite le milieu, au moyen d'un agitateur mécanique à ailettes, jusqu'a obtention d'une suspension homogène appelée ALPHA. Au cours de cette dernière opération, on chauffe lentement le milieu dans une cuve thermostatée, jusqu'à une température voisine de l'ébullition. Il n'est pas nécessaire que l'agitation soit continue mais elle doit être fréquente. L'opération s'arrête lorsqu'on obtient la dissolution complète de la poudre.

Un antibiotique à large spectre antimicrobien est rajouté au milieu ALPHA, à la concentration de 100 mg/L, afin de rendre le milieu ALPHA plus sélectif et de réduire par conséquent le développement de bactéries ou de micro-organismes indésirables.

Le milieu ALPHA est ensuite stérilisé en le passant à l'autoclave à 120°C pendant 15 mn. Après stérilisation il est ensuite ramené à une température de l'ordre de 45°C.

La substance piézo-sensible utilisée dans l'exemple est de la poudre de sel de Seignette. Cette poudre se présente sous forme de grains ayant une taille moyenne de 500 microns et une taille maximale de 1 mm. Ladite poudre est stérilisée au moyen d'une lampe à rayons ultraviolets fonctionnant à une longueur d'onde de 254 nm. Puis elle est ajoutée et mélangée au milieu ALPHA maintenu à une température de 45°C. La température de mélange doit être suffisamment basse pour que la substance piézo-sensible ne soit pas liquéfiée. Le sel de Seignette a, en effet, une température de fusion de 55°C. Après mélange on obtient le milieu BETA.

La quantité de produits piézo-sensibles mélangée dans le milieu de culture est choisie de manière à obtenir une concentration finale non toxique pour les levures. La concentration létale a été déterminée par une étude de cytotoxicité faite au préalable. Elle est de l'ordre de 0,05 g par gramme de milieu ALPHA. On a donc utilisé 25 g de poudre de sel de Seignette pour produire le milieu BETA.

Une solution mère est établie par dilution de manière à obtenir une concentration de 3000 levures par ml de suspension. Comme dans l'exemple 1, les levures utilisées appartiennent à la souche Saccharomyces Cerevisiae.

Des sels de calcium (carbonate de calcium et acétate de calcium) sont utilisés pour fragiliser la membrane des levures. En altérant celle-ci elle devient plus facilement pénétrable. Ces sels de calcium sont préparés à la concentration de 50 g/l.

Pour un milieu de culture BETA donné, contenant du sel de Seignette, on peut donc mélanger 200 µl de solution mère avec 100 µl de carbonate de calcium, ou 200 µl de solution mère avec 100 µl d'acétate de calcium. La solution mère modifiée au moyen de sels de calcium sera appelée GAMMA.

On notera qu'avant utilisation, cette suspension GAMMA est laissée 5 minutes à température ambiante, afin que le sel de calcium puisse agir sur les levures.

La suspension GAMMA est ensuite mélangée à la solution BETA dans la proportion de 100 µl de solution GAMMA pour 50 ml de solution BETA.

Après mélange on laisse reposer le bouillon. La durée d'incubation est de l'ordre de 48 heures à 37°C. Dans cet intervalle la croissance des colonies est contrôlée au moyen de prélèvements réguliers et d'observations au microscope.

La récupération des levures est alors faite par centrifugation à 4500 tours/minute pendant 15 minutes. Le surnageant est éliminé à la pipette et le culot est rincé à l'eau distillée. Il est récupéré, après une seconde centrifugation à 4500 tours/minute pendant 15 minutes, au moyen d'une ou plusieurs micropipettes reliées à un système de contrôle et de commande automatique.

Dans une phase ultérieure, les colonies prélevées sont lyophilisées puis compactées.

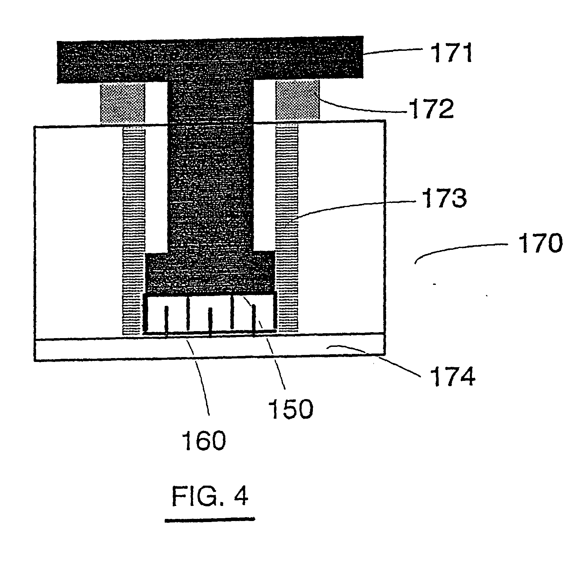

Comme illustré sur la figure 4, le procédé de compactage des particules lyophilisées peut être le suivant. Les électrodes 150,160 choisies dans cet exemple sont du type peigne c'est-à-dire du type de celles décrites dans la demande de brevet FR94.05991. Elles comprennent une plaque 151,161 de dimension 49mm x 49mm, et des lames 152,162 perpendiculaires à ladite plaque, de 1mm d'épaisseur et dont l'espacement, entre deux lames consécutives, est de 3 mm.

Les particules selon l'invention sont réparties entre les lames de l'électrode 150 puis, l'électrode 160 est positionnée de façon à ce que chaque lame 161 de cette dernière soit intercalée entre deux lames de l'électrode 150, et à ce que l'espace entre deux lames consécutives soit de 1mm.

Une pression de 20 MPa est ensuite appliquée pendant cinq minutes, à l'ensemble décrit ci-dessus, à l'aide de l'outillage 170.

Cet outillage comporte principalement un piston 171, deux entretoises 172, un corps de presse 173 et une semelle 174

Ladite pression peut éventuellement être appliquée jusqu'à l'obtention d'un agglomérat homogène, le contrôle de l'homogénéité pouvant être réalisé par un examen visuel et en mesurant les dimensions caractéristiques, au repos, du produit obtenu.

### EXEMPLE 4 (levures et fer en poudre en milieu liquide):

Dans cet exemple de fabrication d'un matériau magnétique selon l'invention en milieu liquide, le procédé et ses étapes sont strictement identiques à l'exemple 3,à l'exception des produits mis en jeu. En effet, une poudre d'oxyde de fer de type FeO.OH d'une masse de 100g se substitue au sel de seignette pour produire le milieu BETA, la concentration létale est de 0,1g par gramme de milieu ALPHA, 100µl de suspension GAMMA sont mélangés à 1500ml de solution BETA.

Afin de contrôler l'efficacité du processus on prélève des levures modifiées par le procédé, on les dépose dans une goutelette d'eau distillée, elle-même placée dans l'entrefer d'un électro-aimant dans lequel l'induction magnétique est d'au moins un Tesla. Les levures forment alors des alignements perpendiculaires aux surfaces des mâchoires de l'électro-aimant.

## Revendications

1. Matériau, piézo-sensible sans FX100, ou magnétique comportant des particules, respectivement piézo-sensibles ou magnétiques et **caractérisé en ce que** ces particules comportent des micro-organismes déshydratés.

2. Matériau piézo-sensible ou magnétique selon la revendication 1, **caractérisé en ce qu'** au moins une partie des particules comportent une enveloppe en matière piézo-sensible, respectivement en matériau magnétique à l'intérieur de laquelle se situe un micro-organisme déshydraté.

3. Matériau piézo-sensible selon la revendication 2, **caractérisé en ce que** les particules de ladite partie sont de forme quasi-sphérique et ont une taille comprise entre 1 et 6 µm.

4. Matériau piézo-sensible selon la revendication 2, **caractérisé en ce que** les particules de ladite partie sont de forme de bâtonnet, la longueur étant comprise entre 1 et 10µm, et la largeur comprise entre 0,5 et 5µm.

5. Matériau piézo-sensible ou magnétique selon la revendication 1, **caractérisé en ce qu'**au moins une partie des particules comportent une enveloppe constituée d'un micro-organisme déshydraté à l'intérieur de laquelle se trouve une particule respectivement piézo-sensible ou magnétique .

6. Matériau magnétique selon l'une quelconque des revendications 1 à 5, **caractérisé en ce que** la matière d'au moins une partie des particules est une poudre d'oxyde de fer.

7. Matériau piézo-sensible selon l'une quelconque des revendications 1 à 5, **caractérisé en ce que** la matière d'au moins une partie des particules est choisie parmi le sel de Seignette, l'acide tartrique, le sulfate de lithium, le dihydrogènephosphate d'ammonium, le dihydrogènephosphate de potassium, le tartrate d'ammonium, le tartrate de potassium, le tartrate de diamine éthylène, le tartrate de dipotassium, le chlorate de sodium, le bromate de sodium, l'hexahydrate de sulfate de nickel, l'acide iodique, le monohydrate de terpène, le benzophénone, le gallate de lithium hydraté, ou déshydraté, les polypeptides synthétiques d'alkylglutamate ou d'arylglutamate, les poly-γ -méthyl-L-glutamates, les poly-γ-benzylglutamates, les copolymères de β-hydroxybutarate ou de β-hydroxyvalérate, les poly-β-hydroxybutarates, les monosaccharides, les disaccharides, les oligosaccharides, les homopolysaccharides, les hétéropolysaccharides, les glycosaminoglycanes, les sels d'acide carboxylique, la brushite, la monétite, les cholestérols et stérols, l'urée, les acides aminés, les dipeptides ou les polypeptides, les nucléotides ou les acides nucléiques.

8. Application d'au moins un matériau selon l'une quelconque des revendications 1 à 6 à un capteur magnétique.

9. Procédé de fabrication d'un matériau piézo-sensible ou magnétique **caractérisé en ce qu'**il consiste :
- à mettre en culture des micro-organismes dans un milieu nourricier et en présence d'une poudre piézo-électrique, ou d'une poudre magnétique, ces micro-organismes étant aptes à fixer ladite poudre,
- à extraire, après culture, les micro-organismes "chargés" du milieu nourricier,
- à déshydrater ces micro-organismes afin d'obtenir des particules sèches,
- à compacter lesdites particules ou à les insérer dans une matrice pour constituer un matériau composite pour former un matériau piézo-sensible ou magnétique.

10. Procédé de fabrication d'un matériau piézo-sensible ou magnétique selon la revendication 9, **caractérisé en ce qu'**il consiste en outre, après avoir déshydraté les micro-organismes chargés, à séparer les particules piézo-sensible des micro-organismes.

11. Procédé de fabrication d'un matériau piézo-sensible selon l'une quelconque des revendications 9 et 10, **caractérisé en ce que** la déshydratation des micro-organismes est réalisée par lyophilisation.

12. Procédé de fabrication d'un matériau piézo-sensible selon l'une quelconque des revendications 9 à 11, **caractérisé en ce que** l'extraction des micro-organismes chargés de la culture est réalisée par centrifugation.

13. Procédé de fabrication d'un matériau piézo-sensible selon la revendication 10, **caractérisé en ce que** la séparation consiste à plonger les micro-organismes chargés dans de l'eau de Javel.

## Patentansprüche

1. Ohne FX100 piezoelektrisch erregbares oder magnetisches Material, das entsprechend piezoelektrisch erregbare oder magnetische Teilchen umfaßt, **dadurch gekennzeichnet, daß** diese Teilchen dehydratisierte Mikroorganismen enthalten.

2. Piezoelektrisch erregbares oder magnetisches Material nach Anspruch 1, **dadurch gekennzeichnet, daß** mindestens ein Teil der Teilchen eine Hülle aus piezoelektrisch erregbarem Material bzw. magnetischem Material aufweisen, in deren Innerem sich ein dehydratisierter Mikroorganismus befindet.

3. Piezoelektrisch erregbares Material nach Anspruch 2, **dadurch gekennzeichnet, daß** die Teilchen des Teils in etwa kugelförmig sind und eine Teilchengröße von zwischen 1 und 6 µm aufweisen.

4. Piezoelektrisch erregbares Material nach Anspruch 2, **dadurch gekennzeichnet, daß** die Teilchen des Teils die Form von Stäbchen aufweisen, deren Länge zwischen 1 und 10 µm und deren Breite zwischen 0,5 und 5 µm betragen.

5. Piezoelektrisch erregbares oder magnetisches Material nach Anspruch 1, **dadurch gekennzeichnet, daß** mindestens ein Teil der Teilchen eine Hülle aufweisen, die aus einem dehydratisierten Mikroorganismus gebildet ist und in deren Innerem sich entsprechend ein piezoelektrisch erregbares oder magnetisches Teilchen befindet.

6. Magnetisches Material nach einem der Ansprüche 1 bis 5, **dadurch gekennzeichnet, daß** mindestens ein Teil der Teilchen aus einem Eisenoxidpulver besteht.

7. Piezoelektrisch erregbares Material nach einem der Ansprüche 1 bis 5, **dadurch gekennzeichnet, daß** mindestens ein Teil der Teilchen aus einem Stoff besteht, der aus den folgenden ausgewählt ist: Seignettesalz, Weinsäure, Lithiumsulfat, Ammoniumdihydrogenphosphat, Kaliumdihydrogenphosphat, Ammoniumtartrat, Kaliumtartrat, Ethylendiamintartrat, Dikaliumtartrat, Natriumchlorat, Natriumbromat, Nickelsulfat-Hexahydrat, lodsäure, Terpen-Monohydrat, Benzophenon, hydratisiertes oder dehydratisiertes Lithiumgallat, synthetische Polypeptide von Alkylglutamat oder Arylglutamat, Poly-γ-methyl-Lglutamate, Poly-γ-benzylglutamate, Copolymere von β-Hydroxybutyrat oder von β-Hydroxyvalerat, Poly-β-hydroxybutyrate, Monosaccharide, Disaccharide, Oligosaccharide, Homopolysaccharide, Heteropolysaccharide, Glykosaminglykane, Carbonsäuresalze, Brushit, Monetit, Cholesterine und Sterine, Harnstoff, Aminosäuren, Dipeptide oder Polypeptide, Nukleotide oder Nukleinsäuren.

8. Verwendung mindestens eines Materials gemäß einem der Ansprüche 1 bis 6 für einen Magnetsensor.

9. Verfahren zur Herstellung eines piezoelektrisch erregbaren oder magnetischen Materials, **gekennzeichnet durch** folgende Schritte:
- Kultivieren von Mikroorganismen in einem Nährmedium und in Gegenwart eines piezoelektrischen Pulvers oder eines magnetischen Pulvers, wobei die Mikroorganismen zur Fixierung des Pulvers befähigt sind;
- Extrahieren der "beladenen" Mikroorganismen aus dem Nährmedium nach dem Kultivieren;
- Dehydratisieren dieser Mikroorganismen, um trockene Teilchen zu erhalten;
- Kompaktieren der Teilchen oder Einbringen der Teilchen in eine Matrix unter Bildung eines Verbundmaterials, zur Bildung eines piezoelektrisch erregbaren oder magnetischen Materials.

10. Verfahren zur Herstellung eines piezoelektrisch erregbaren oder magnetischen Materials nach Anspruch 9, **dadurch gekennzeichnet, daß** zusätzlich, nachdem die beladenen Mikroorganismen dehydratisiert worden sind, die piezoelektrisch erregbaren Teilchen von den Mikroorganismen abgetrennt werden.

11. Verfahren zur Herstellung eines piezoelektrisch erregbaren Materials nach einem der Ansprüche 9 oder 10, **dadurch gekennzeichnet, daß** die Dehydratisierung der Mikroorganismen durch Gefriertrocknung erfolgt.

12. Verfahren zur Herstellung eines piezoelektrisch erregbaren Materials nach einem der Ansprüche 9 bis 11, **dadurch gekennzeichnet, daß** die Extraktion der beladenen Mikroorganismen aus der Kultur durch Zentrifugieren erfolgt.

13. Verfahren zur Herstellung eines piezoelektrisch erregbaren Materials nach Anspruch 10, **dadurch gekennzeichnet, daß** das Abtrennen durch Eintauchen der beladenen Mikroorganismen in Kalibleichlauge (Eau de Javel) erfolgt.

## Claims

1. FX100-free piezo-sensitive material or magnetic material comprising particles which are either piezo-sensitive or magnetic, and **characterized in that** these particles comprise dehydrated microorganisms.

2. Piezo-sensitive or magnetic material according to Claim 1, **characterized in that** at least one portion of the particles comprises an envelope of piezo-sensitive material or of magnetic material, inside which is a dehydrated microorganism.

3. Piezo-sensitive material according to Claim 2, **characterized in that** the particles of the said portion are of quasi-spherical shape and are between 1 and 6 µm in size.

4. Piezo-sensitive material according to Claim 2, **characterized in that** the particles of the said portion are stick-shaped, the length being between 1 and 10 µm and the width being between 0.5 and 5 µm.

5. Piezo-sensitive or magnetic material according to Claim 1, **characterized in that** at least one portion of the particles comprises an envelope consisting of a dehydrated microorganism inside which is a piezo-sensitive particle or a magnetic particle.

6. Magnetic material according to any one of Claims 1 to 5, **characterized in that** the material of at least one portion of the particles is an iron oxide powder.

7. Piezo-sensitive material according to any one of Claims 1 to 5, **characterized in that** the material of at least one portion of the particles is selected from Rochelle salt, tartaric acid, lithium sulfate, ammonium dihydrogen phosphate, potassium dihydrogen phosphate, ammonium tartrate, potassium tartrate, ethylenediamine tartrate, dipotassium tartrate, sodium chlorate, sodium bromate, nickel sulfate hexahydrate, iodic acid, terpene monohydrate, benzophenone, hydrated or anhydrous lithium gallate, alkylglutamate or arylglutamate synthetic polypeptides, poly-γ-methyl-L-glutamates, poly-γ-benzylglutamates, β-hydroxybutyrate or β-hydroxyvalerate copolymers, poly-β-hydroxybutyrates, monosaccharides, disaccharides, oligosaccharides, homopolysaccharides, heteropolysaccharides, glycosaminoglycans, carboxylic acid salts, brushite, monetite, cholesterols and sterols, urea, amino acids, dipeptides or polypeptides, nucleotides and nucleic acids.

8. Application of at least one material according to any one of Claims 1 to 6, to a magnetic sensor.

9. Process for manufacturing a piezo-sensitive or magnetic material, **characterized in that** it consists of:
- culturing microorganisms in a nutrient medium and in the presence of a piezoelectric powder or a magnetic powder, these microorganisms being capable of fixing the said powder,
- after culturing, extracting the "charged" microorganisms from the nutrient medium,
- dehydrating these microorganisms in order to obtain dry particles,
- compacting the said particles or inserting them into a matrix to make a composite material to form a piezo-sensitive or magnetic material.

10. Process for manufacturing a piezo-sensitive or magnetic material according to Claim 9, **characterized in that** it also consists of separating the piezo-sensitive particles from the microorganisms, after the charged microorganisms have been dehydrated.

11. Process for manufacturing a piezo-sensitive material according to either of Claims 9 and 10, **characterized in that** the microorganisms are dehydrated by freeze-drying.

12. Process for manufacturing a piezo-sensitive material according to any one of Claims 9 to 11, **characterized in that** the charged microorganisms are extracted from the culture by centrifugation.

13. Process for manufacturing a piezo-sensitive material according to Claim 10, **characterized in that** the separation consists of immersing the charged microorganisms in bleach.
